Europäisches Patentamt

European Patent Office

Office européen des brevets

(19)

(11) Publication number:

**0 359 477**

**A2**

# EUROPEAN PATENT APPLICATION

(12)

(21) Application number: **89309107.4**

(22) Date of filing: **08.09.89**

(51) Int. Cl.5: **H03F 1/34 , H03F 3/19 , H03F 1/32**

(30) Priority: **13.09.88 FI 884213**

(43) Date of publication of application:
**21.03.90 Bulletin 90/12**

(84) Designated Contracting States:
**AT BE CH DE ES FR GB GR IT LI LU NL SE**

(71) Applicant: **NOKIA MOBILE PHONES LTD.**
**P.O. Box 86**
**SF-24101 Salo(FI)**

(72) Inventor: **Lonka, Pekka Sakari**
**Alastuvankatu 3 as. 4**
**SF-24240 Salo(FI)**
Inventor: **Savojoki, Jari-Pekka**
**Taskulantie 2 B 20**
**SF-20300 Turku(FI)**

(74) Representative: **Alexander, Thomas Bruce et al**
**Boult, Wade & Tennant 27 Furnival Street**
**London EC4A 1PQ(GB)**

(54) **Linearization of an amplification in an RF amplifier.**

(57) The invention relates to the linearization of an amplification in a radio frequency amplifier. The radio frequency amplifier (B) is coupled to a transmission signal line by means of connectors (TX IN, TX OUT). At points before and after the power amplifier stage (Q1, Q2, Q3) there are coupled directional couplers (Sk1, Sk2), on the basis of information from which the gain control circuit of the radio frequency amplifier (B) controls the power amplifier (Q1, Q2, Q3) in such a manner that its amplification is linear and constant.

FIG. 2

EP 0 359 477 A2

Xerox Copy Centre

## Linearization of an amplification in an RF amplifier

The invention relates to the radio-frequency amplifier of a radio telephone, for example a mobile telephone, and specifically to its linear amplification.

It is known to increase the radiated power of the antenna of a mobile telephone (for example a hand telephone) by installing in front of the antenna an antenna amplifier which is a radio-frequency amplifier. This amplifier increases the radiated power by increasing the supply current of the antenna, whereupon the radiated power increases in proportion to the current squared. The amplifier response has to be linear in such a manner that it follows the incoming power level, amplifying it by a constant.

In a prior-art embodiment, the radio-frequency amplifier comprises a regulator circuit for the amplifier operating voltages, a preamplifier and power-amplifier circuit for the amplification of the transmission signal, and a power amplifier power regulator circuit.

The power regulator circuit has an operational amplifier, which controls the power levels of the power amplifier by regulating their supply voltages. The operational amplifier for its part is controlled by means of a separate control circuit, which comprises an IC-circuit with its control lines and connectors, from which the lines of external control are led to the IC-circuit.

A prior-art system such as this, in which separate control lines with their connectors are used for power control, involves certain disadvantages. The cabling and the connectors easily cause stray radiation and increase disturbances. The additional components and the connectors required take up space and also increase possibilities for error. When it has been desired to couple an antenna amplifier to an already existing hand telephone which does not have separate control lines, it has been difficult to implement this addition.

The object of the invention is to provide a method and device for the linearization of an amplification in an RF amplifier, eliminating the disadvantages described above. This is achieved in the manner indicated in Claims 1 and 2.

The invention is described below in greater detail with reference to the accompanying figures, in which:

Figure 1 depicts the location of the RF amplifier in a mobile telephone,

Figure 2 is a block diagram of the RF amplifier, showing the coupling of the amplifier according to the invention to the antenna line,

Figure 3 is a detailed circuit diagram of one embodiment of the RF amplifier.

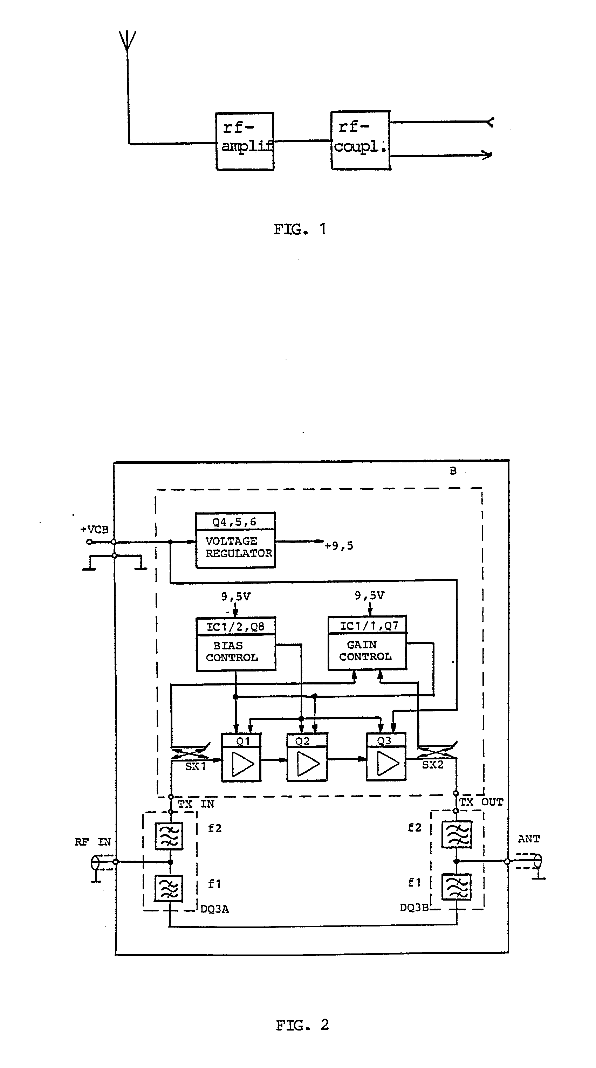

Figure 1 shows that the RF amplifier, which hereinafter is called simply a booster, is located between the antenna and the RF coupler. The coupler is used for directing in a known manner the incoming signal to the receiver and the transmission signal to the antenna. The transmission signal is amplified by means of the booster, whereas the incoming signal is applied directly to the receiver.

In the booster block diagram depicted in Figure 2, the received signal passes from the antenna to a duplex filter DQ3B. The filter is a two-part bandpass filter, and its part f2 is visible at the reception frequency as an impedance high for the signal, whereas f1 is visible as having the magnitude of the antenna impedance. The signal then proceeds to a second duplex filter DQ3A, the impedances of the partial filters of which are such that the received signal proceeds to the receiver in a known manner. Respectively, when a signal is being transmitted, the impedances of the partial filters of the duplex filters are so calibrated that the signal, which comes from the transmitter in a known manner, passes through the part f2 of the filter DQ3A, the booster unit B, and the duplex filter DQ3B part f2 to the antenna. What has been described above is known per se and self-evident for an expert in the art. The actual object of the invention is the booster unit B.

The booster unit B comprises, in accordance with the principle of Figure 2, a three-step AB-class amplifier chain Q1, Q2, Q3, a voltage regulator, an gain control circuit GC, and a switching circuit for the bias voltages of the amplifiers Q1, Q2 and Q3.

According to the main principle of the invention, the power of the amplifiers Q1, Q2 and Q3 is not controlled by means of external separate control lines; instead, the control is effected by power controlled by the hand telephone, by using only the antenna cable. More precisely, such utilization of the antenna cable in power control is implemented by using, in accordance with the invention, suitably calibrated directional couplers Sk1 and Sk2 in the input and the output of the amplifier chain, the gain control being based on the utilization of the voltage information obtained from these directional couplers, in the manner described below. A directional coupler is a coupler made up of two wires so connected that an electromagnetic wave traveling in one of them induces a wave in the same direction in the other conductor. Through the use of directional couplers, a linear response is achieved in the booster, whereupon the booster follows the incoming power levels (for example, the transmission power levels of a mobile telephone) and amplifies them by a constant. The directional coupler may be a coupler manufactured by any suitable technique, for example a strip line coupler, micro strip coupler or coaxial coupler.

The voltage regulator is used for adjusting to the required constant value the voltage +VB, filtered from the supply voltage +VCB. This voltage is needed for the gain control circuit and in the setting of the bias voltages of the amplifiers Q1, Q2 and Q3.

The gain control circuit operates as follows: the voltage data received from the directional couplers Sk1 and Sk2 are compared, and the amplification of the amplifiers Q1, Q2 and Q3 is controlled in such a manner that the voltages are the same before and after the power amplification, in other words the transmission signal voltage coming to the directional coupler Sk1 is the same as the signal voltage, amplified by the amplifiers Q1, Q2, Q3, leaving the directional coupler Sk2.

The bias voltages of the amplifiers Q1, Q2, Q3 are observed by the switching circuit of the bias voltages. It observes whether there is a transmission signal and whether the gain control circuit has switched the supply voltages to the amplifiers. If this is the case, the bias voltages are switched to the base of the amplifiers Q1, Q2, Q3, whereupon the amplifier chain is in operation.

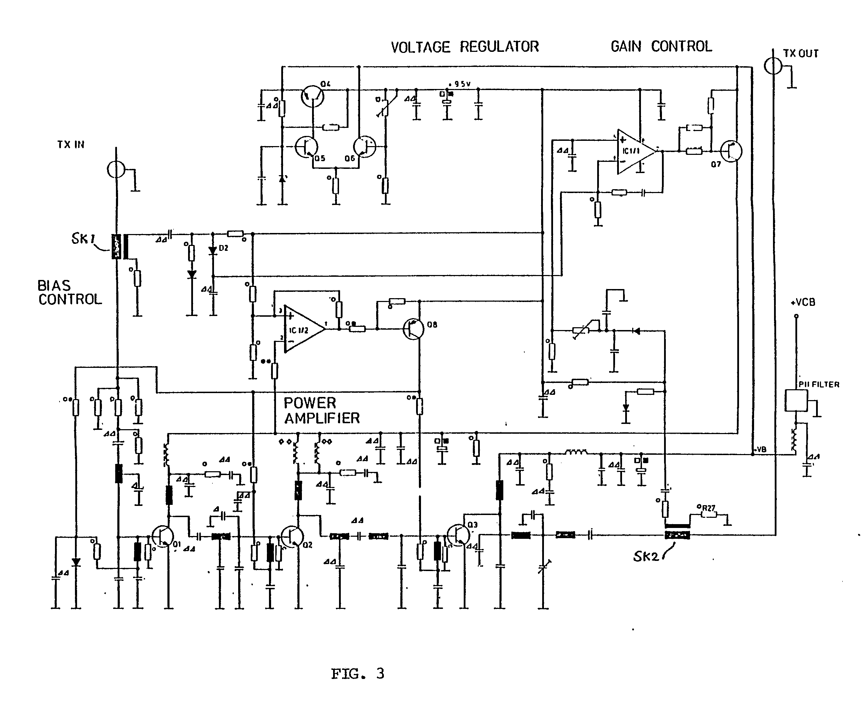

The booster operation according to the invention, described above, is described below in greater detail, with reference primarily to the circuit diagram of an embodiment according to Figure 3.

In transmission, the signal comes from the connector TX IN of the duplex filter DQ3A via the directional coupler Sk1 to the booster, and further, via the amplifier chain Q1, Q2, Q3, amplified, via the directional coupler Sk2 to the duplex filter DQ3A, and further to the antenna. The voltage, induced by the transmission signal and obtained from the directional coupler Sk1, is rectified by means of the diode D2 and is applied to the inverting input of the amplifier IC 1/1 of the gain control circuit. Correspondingly, the voltage induced in the directional coupler Sk2 by the power-amplified signal is applied to the non-inverting input of the said amplifier. The amplifier controls, via the transistor Q7, the supply voltages of the power amplifiers Q1 and Q2 so that the signal voltages before and after the power amplifier chain are equal. If there is no transmission signal, i.e. if there is no power traveling through the connector TX IN, the gain control circuit closes the transistor Q7, whereupon the two first stages of the power amplifier will not receive supply voltage. The amplification of the amplifier IC 1/1 can be adjusted by changing the value of the resistor R27.

The voltage of the voltage regulator (D8, Q4-Q6) is applied via the transistor Q7 as the supply voltage for the first amplifier stage Q1 and Q2 of the power amplifier, but the supply voltage +VB of the terminal transistor Q3 of the power amplifier is filtered from the supply voltage +VCB.

The operational amplifier IC 1/2 belonging to the switching circuit for bias voltages observes whether there is a transmission signal, i.e. whether there is an induced signal coming via the directional coupler Sk1 to the noninverting input and whether the supply voltages are switched to the first two stages Q1 and Q2 of the power amplifier, i.e. the supply voltage produced by the gain control circuit is also applied to the inverting input of the operational amplifier. If there is voltage in both terminals, the bias voltages are switched via the transistor Q8.

As can be seen from what has been described above, the power amplification is controlled automatically by means of merely the transmission signal power from the antenna line, and no separate control lines with connectors are necessary for the power regulation. The amplification is linear and, for example, the power levels of a mobile telephone are amplified by a constant. In the booster implementation according to the invention, the elimination of separate control and regulation lines provides many advantages over the commonly used systems. Since efforts are made to make the structure of a mobile telephone very compact, it is advantageous that the space requirement due to the extra cables and connectors required by separate control and adjustment lines is eliminated. The system according to the invention also reduces stray radiation and various other disturbance problems, since the cabling requirement is reduced. This leads to a greater ease of installation and, since separate control lines with connectors are not needed, also to a less expensive structure.

It should be noted that by means of the booster according the invention, the transmission power of a mobile telephone has been increased by 8 dB.

One embodiment of the invention has been described above, but it is evident that the practical implementation of the circuitry of the booster may vary greatly within the basic inventional idea.

## Claims

1. A method for the linearization of an amplification in the radio frequency amplifier of a radio telephone, for example a mobile telephone, wherein the radio frequency amplifier (B) is coupled in front of the antenna to that branch of the loop defined by two duplex filters (DQ3A, DQ3B), coupled opposite to each other, in which the signal to be transmitted is traveling, **characterized** in that the power of the radio frequency amplifier is controlled directly by the transmission power of the mobile telephone, by using only the antenna cable.

2. A coupling arrangement for the linearization of the radio frequency amplification of a radio telephone, for example a mobile telephone, wherein the radio frequency amplifier (B) is coupled in front of the antenna, in that branch of the loop defined by two duplex filters (DQ3A, DQ3B), coupled opposite to each other, in which the signal to be transmitted is traveling, the radio frequency amplifier comprising a power amplifier (Q1, Q2, Q3), a switching circuit for bias voltages, an amplifier power gain control circuit, and a voltage regulation circuit, **characterized** in that coupled to the input and the output of the radio frequency amplifier (B) there are means (Sk1, Sk2) on the basis of the information from which the control circuit for the power gain of the radio frequency amplifier controls the power amplification of the radio frequency amplifier (B) in such a manner that the amplification is linear and constant.

3. A coupling arrangement according to Claim 2, **characterized** in that the means coupled to the input and the output of the radio frequency amplifier are directional couplers (Sk1, Sk2).

4. A coupling arrangement according to Claim 2, **characterized** in that the power of the radio frequency amplifier (B) is controlled so that the voltage received from each directional coupler (Sk1, Sk2) is equally high.

5. A coupling arrangement according to Claim 2, **characterized** in that the booster gain control circuit is coupled so that, if there is no transmission power coming to the first directional coupler (Sk1), the control circuit switches off the supply voltage of the power amplifiers (Q1, Q2) of the radio frequency amplifiers.

6. A coupling arrangement according to Claim 2, characterized in that the switching circuit for the bias voltages switches the bias voltages to the power amplifiers (Q1, Q2, Q3) only if there is transmission power coming to the first directional coupler (Sk1) and if the supply voltages of the power amplifiers (Q1, Q2) of the radio frequency amplifier (B) are on.

FIG. 1

FIG. 2

VOLTAGE REGULATOR    GAIN CONTROL

FIG. 3

EP 0 359 477 A2